# EUROPÄISCHE PATENTSCHRIFT

(11) **EP 1 503 398 B1**
(45) Veröffentlichungstag und Bekanntmachung des Hinweises auf die Patenterteilung: **09.03.2011**
(21) Anmeldenummer: 04017632.3
(22) Anmeldetag: 26.07.2004
(51) Int. Cl.: H01J 37/20, H01J 37/26

(54) **Elektronenstrahlgerät mit Präparathalter**
Electron beam apparatus with specimen holder
Appareil à faisceau d'électrons avec porte-échantillon

(30) Priorität: 31.07.2003 DE 10335504
(43) Veröffentlichungstag der Anmeldung: 02.02.2005
(73) Patentinhaber: Carl Zeiss NTS GmbH, 73447 Oberkochen (DE)
(72) Erfinder: Hiller, Stephan, 73434 Aalen (DE); Niebel, Harald, 73447 Oberkochen (DE); König, Richard, 74585 Rot am See (DE)
(74) Vertreter: Patentanwälte Freischem

(56) Entgegenhaltungen:
- EP-A- 0 510 618
- WO-A-89/01698
- PATENT ABSTRACTS OF JAPAN Bd. 2002, Nr. 12, 12. Dezember 2002 (2002-12-12) & JP 2002 216693 A (JEOL LTD), 2. August 2002 (2002-08-02)

## Beschreibung

Die Erfindung betrifft ein Elektronenstrahlgerät mit einem Präparathalter, insbesondere ein Transmissionselektronenmikroskop (TEM).

Schon seit längerem werden Präparathalter, die in einem Elektronenstrahlgerät eingesetzt werden, kippbar ausgebildet. Die Kippung eines zu untersuchenden Präparats ist bei verschiedenen Untersuchungsmethoden, die bei einem Elektronenstrahlgerät angewendet werden, von Vorteil. Zur Winkeleinstellung wird in der Regel ein Goniometer verwendet. Allerdings weisen Präparathalter verschiedener Hersteller unterschiedliche Maximal-Kippwinkel auf. Da in einem Elektronenstrahlgerät je nach zu untersuchendem Präparat und angewandter Untersuchungsmethode durchaus unterschiedliche Präparathalter eingesetzt werden, hat dies zur Folge, daß Bewegungsabläufe des Goniometers in Abhängigkeit von einem in einem Elektronenstrahlgerät eingesetzten Präparathalter erfolgen müssen. Insbesondere bedingen bestimmte Präparathalter eine Einschränkung ihres Kippwinkels in Abhängigkeit der Objektivlinse des Elektronenstrahlgeräts und der von einem Benutzer eingestellten Bewegungsachsen.

Zur Identifikation der verschiedenen Präparathalter ist es bislang bekannt, an dem Präparathalter Kontakte zur Halterindizierung anzubringen, die mit Kontakten einer Steckverbindung in Verbindung gebracht werden. Mittels der Indizierung wird der Präparathalter identifiziert. Hierbei ist allerdings von Nachteil, daß die Steckverbindung stets gesteckt werden muß. Ferner ist es von Nachteil, daß Anwender sehr oft Präparathalter unterschiedlicher Hersteller verwenden. Hierbei besteht zum einen das Problem, daß sich die Hersteller der einzelnen Präparathalter auf ein Indizierungssystem einigen müssen, da ansonsten beim Auslesen der Indizierung Fehler bei der Zuordnung sowie Identifikation der einzelnen Präparathalter und somit bei der Einstellung der Kippwinkel auftreten können. Zum anderen eignen sich auch einige Elektronenstrahlgeräte konstruktions- und leistungsbedingt nur zur Aufnahme von Präparathaltern eines einzelnen Herstellers, die eine ausreichend gute Funktionsweise und den ordnungsgemäßen Betrieb des Elektronenstrahlgeräts mit sicherstellen.

Alternativ ist es bekannt, daß die zum Probenhalter zugehörigen Daten von einer Steuerungssoftware des Elektronenstrahlgerätes oder eines daran aufgenommenen Goniometers bei einem Wechsel des Probenhalters abgefragt und vom Benutzer entsprechend eingegeben werden müssen. Falscheingaben mit gravierenden Folgen für den Probenhalter und/oder die Objektivlinse sind dadurch möglich.

Aus der WO89/01698A sind die Merkmale des Oberbegriffs von Anspruch 1 bekannt. Dieses Dokument offenbart ein Rasterelektronenmikroskop, mit einer Elektrode mit einer Vielzahl von Präparathaltern 16, die jeweils ein Halteelement 20 zum Halten eines Präparats aufweisen sowie eine Identifikationseinheit 25, z.B. einen Barcode, der berührungslos durch eine Leseeinheit auslesbar ist.

Auch aus dem Dokument JP2002-216693A ist ein Elektronenstrahlgerät (TEM) mit einem Präparathalter 52 zum Halten eines Präparats 55 bekannt, wobei der Präparathalter einen Barcode 57 aufweist, der berührungslos durch einen Barcodeleser 63 auslesbar ist.

Der Erfindung liegt die Aufgabe zugrunde, in einem Elektronenstrahlgerät mit einer einfachen, berührungslosen Identifikation eines Präparathalters die Bewegungsmodi eines Goniometers, mit dem ein bestimmbarer Kippwinkel des Präparathalters eingestellt wird, aufgrund der Art des Präparathalters einfach anzupassen und gegebenenfalls zu begrenzen.

Diese Aufgabe wird durch ein Elektronenstrahlgerät mit den Merkmalen des Anspruchs 1 gelöst.

Das erfindungsgemäße Elektronenstrahlgerät, insbesondere ein Transmissionselektronenmikroskop, weist mindestens einen Präparathalter auf, der mindestens ein Halteelement zum Halten eines Präparats und mindestens eine Identifikationseinheit aufweist. Ferner weist das Elektronenstrahlgerät eine Leseeinheit zum berührungslosen Auslesen der Identifikationseinheit, ein Goniometer, in das der Präparathalter einführbar ist, und eine Steuerung zur Steuerung der Bewegungsmodi des Goniometers auf, wobei mit der Steuerung auf Grundlage der von der Leseeinheit aus der Identifikationseinheit ausgelesenen Identifikationsdaten und in der Steuerung gespeicherter Daten die Bewegungsmodi des Goniometers gesteuert werden. Der erfindungsgemäße Präparathalter weist den Vorteil auf, daß er keine Steckverbindung benötigt. Somit ist der Austausch des Präparathalters sehr einfach. Die Identifikationseinheit erlaubt eine eindeutige Indizierung der verschiedenen Ausführungen von Präparathaltern. Insbesondere werden einzelne Ausführungen eines einzelnen Herstellers eindeutig erkannt. Sollte ein Präparathalter verwendet werden, der nicht eindeutig identifizierbar ist oder einem Hersteller zugeordnet wird, dessen Präparathalter nicht in dem Elektronenstrahlgerät verwendet werden sollen, so wird eine Steuerelektronik sowohl den Präparathalter als auch das Elektronenstrahlgerät nicht oder nur mit Einschränkung zur Benutzung freigeben.

Bei der Erfindung ist es vorgesehen, die Identifikationseinheit aktiv oder passiv auszubilden. Hierunter wird verstanden, daß die Ideritifikationseinheit eine eigene Spannungsversorgung aufweist (aktiv) oder über eine derartige Spannungsversorgung nicht verfügt (passiv). Die letztgenannte Ausführungsform ist dabei besonders gut geeignet, da sie besonders einfach auszuführen ist.

Des weiteren ist vorzugsweise vorgesehen, die Identifikationseinheit optisch und/oder magnetisch auszubilden und diese durch eine optische und/oder magnetische Leseeinheit auszulesen. Beispielsweise ist vorgesehen, die Identifikationseinheit als Transponder auszubilden. Vorzugsweise weist der Transponder mindestens eine Hochfrequenzspule auf, der auf bereits bekannte Weise Energie zugeführt wird, die einem entsprechenden Code (Identifikationsnummer) entspricht. Dieser Code ist beispielsweise mit einer Leseeinheit auslesbar, die als Empfangsspule ausgebildet ist. Die vorgenannte Ausführungsform beruht auf dem Induktionsprinzip, das bereits seit langem bekannt ist.

Wie oben bereits erwähnt, kann die Identifikationseinheit aber auch optisch ausgebildet sein. Hierzu ist vorzugsweise an dem Präparathalter mindestens ein Barcode (Strichcode) angeordnet, der durch einen optischen Scanner erkannt und ausgelesen wird. Hierzu eignet sich beispielsweise ein Laserscanner, der nur einen geringen Bauplatz benötigt.

Wie oben erwähnt, weist der erfindungsgemäße Präparathalter mindestens ein Halteelement zum Halten eines Präparats auf. Dieses Halteelement ist vorzugsweise an einem Griffstück angeordnet, mit dem der Präparathalter in die Hand genommen wird. Um das Halteelement möglichst klein auszubilden und um somit einen geringen Bauplatz im Elektronenstrahlgerät zu benötigen, ist die Identifikationseinheit vorzugsweise an dem Griffstück angeordnet.

Ferner ist dem Elektronenstrahlgerät eine Auswerteelektronik zugeordnet, die die aus der Identifikationseinheit ausgelesenen Daten einem Steuergerät des Elektronenstrahlgerätes und/oder einem Steuergerät des Goniometers zuführt. Die Leseeinheit ist vorzugsweise in oder an einem Goniometer angeordnet, in das der Präparathalter einführbar ist.

Die in der Steuerung gespeicherten Daten umfassen vorzugsweise Datensätze, die Bewegungsabläufe (Bewegungsmodi) für mehrere unterschiedliche Präparathalter beschreiben, wobei jeweils ein Datensatz einem bestimmten Präparathalter zugeordnet und nicht veränderbar ist. Nach der eindeutigen Identifizierung des Präparathalters ist demnach eine genaue Positionierung des Präparathalters mittels des Goniometers leicht möglich.

Der beschriebene Präparathalter eignet sich besonders gut für ein Transmissionselektronenmikroskop. Die Erfindung ist allerdings nicht auf derartige Mikroskope eingeschränkt. Sie eignet sich für jedes Teilchenstrahlgerät, das einen Präparathalter benötigt.

Nachfolgend wird die Erfindung anhand von Ausführungsbeispielen gemäß den nachfolgenden Figuren erläutert. Es zeigen:
Fig.1 einen Schnitt entlang einer optischen Achse durch ein Transmissionselektronenmikroskop;
Fig. 2 eine schematische Darstellung eines Identifikationssystems mit einem Präparathalter;
Fig. 3 eine schematische Darstellung eines weiteren Identifikationssystems mit einem Präparathalter; und
Fig. 4 eine Draufsicht auf ein Griffstück des Präparathalters gemäß Fig. 3.

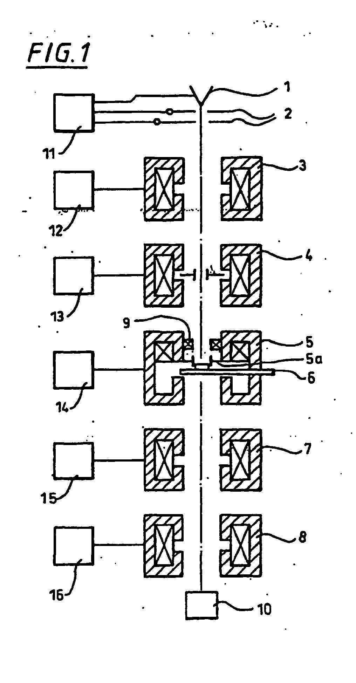

Fig. 1 stellt eine schematische Darstellung eines erfindungsgemäßen Transmissionselektronenmikroskops dar, welches das erfindungsgemäße Identifikationssystem mit dem erfindungsgemäßen Präparathalter aufweist.

Das Transmissionselektronenmikroskop (TEM) weist eine Elektronenquelle 1 mit einer nachgeordneten Beschleunigungsstufe 2 auf, die die aus der Elektronenquelle 1 austretenden Elektronen (nachfolgend auch Primärelektronen genannt) beschleunigt. Zur weiteren Strahlformung des aus der Elektronenquelle 1 austretenden Primärelektronenstrahls ist ein aus zwei Magnetlinsen 3,4 bestehendes Kondensorsystem vorgesehen. Den beiden Kondensorlinsen 3,4 ist eine Kondensor-Objektiv-Einfeldlinse 5 sowie eine Vorfeldblende 5a nachgeordnet, wie sie bereits beispielsweise aus der DE 199 45 344 A1 bekannt ist. In der Kondensor-Objektiv-Einfeldlinse 5 ist ein durch ein nicht dargestelltes Goniometer winkelverstellbarer Präparathalter 6 angeordnet, der nachfolgend noch näher beschrieben wird. Ferner sind Spulen 9 vorgesehen, die als Ablenksystem in einem Rasterbetrieb (STEM) dienen.

Der Kondensor-Objektiv-Einfeldlinse 5 ist ein mehrstufiges System aus Magnetlinsen 7,8 nachgeordnet, die zur vergrößerten Abbildung eines Präparats auf einem Detektor 10 dienen. Ferner sind in Fig. 1 die für die Versorgung der einzelnen elektronenoptischen Komponenten erforderlichen Steuerund Versorgungseinheiten 11 - 16 dargestellt.

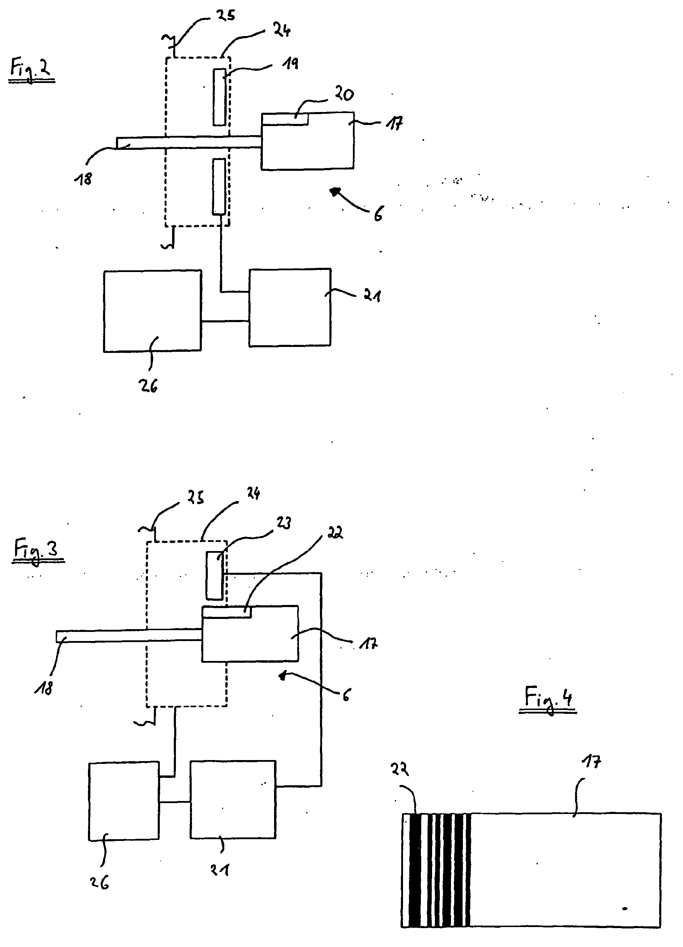

Fig. 2 zeigt in einer schematischen Darstellung das in dem Transmissionselektronenmikroskop gemäß Fig. 1 angeordnete Identifikationssystem für den Präparathalter 6. Der Präparathalter 6 weist ein Halteelement 18 auf, an dem das Präparat zur Untersuchung angeordnet wird. Dem Halteelement 18 ist ein Griffstück 17 nachgeordnet, das an einer seiner Seiten einen Transponder 20 aufweist. Der Transponder 20 umfaßt eine oder mehrere Hochfrequenzspule(n). Ferner wurde dem Transponder 20 auf bekannter Weise ein Code (Identifikationsnummer) zugeführt, der die Identifikation des Präparathalters 6 eindeutig ermöglicht.

Wie oben bereits erwähnt, ist am Transmissionselektronenmikroskop, dessen Säule 25 schematisch in Fig. 2 dargestellt ist, ein Goniometer 24 angeordnet, an dem bzw. in dem eine Empfangsspule 19 angeordnet ist, die mit einer Auswerteelektronik 21 verbunden ist. Beim Einführen des Präparathalters 6 in das Goniometer 24 kommt es bei Annäherung des Transponders 20 an die Spule 19 zu einer induktiven Kopplung, die mittels der Auswerteelektronik 21 ausgewertet wird. Auf diese Weise erhält man den im Transponder 20 implementierten Code zur Identifizierung des Präparathalters 6. Aufgrund der Auswertung durch die Auswerteelektronik 21 sowie gegebenenfalls weiterer Daten, die in einer Goniometersteuerung 26 gespeichert sein können, werden dann Bewegungsmodi des Goniometers 24 und somit die Bewegung des Präparathalters 6 gesteuert.

Ein weiteres Ausführungsbeispiel ist schematisch in der Fig. 3 dargestellt. Gleiche Bauteile sind mit gleichen Bezugszeichen versehen. Im Unterschied zu dem in Fig. 2 dargestellten Ausführungsbeispiel ist an einer Seite des Griffstücks 17 ein Barcode 22 (Strichcode) angeordnet, der mittels eines Laserscanners 23 ausgelesen werden kann. Auf diese Weise wird der Präparathalter 6 identifiziert. Der Barcode 22 kann (wie auch der Transponder 20) an jeder Stelle des Griffstücks 17 bzw. des Präparathalters 6 angeordnet werden (vgl. auch Fig. 4).

Der erfindungsgemäße Präparathalter bzw. das erfindungsgemäße Identifikationssystem weist den Vorteil auf, daß keine Steckverbindung benötigt wird. Der Austausch eines Präparathalters ist daher sehr einfach. Ferner ermöglicht die Identifikationseinheit (im Ausführungsbeispiel ausgestaltet als Transponder oder Barcode) eine eindeutige Indizierung und Identifikation der verschiedenen Ausführungen von Präparathaltern. Sollte jedoch ein Präparathalter verwendet werden, der nicht eindeutig identifizierbar ist oder einem Hersteller zugeordnet wird, dessen Präparathalter nicht in dem Transmissionselektronenmikroskop verwendet werden sollen, so wird eine Steuerelektronik sowohl den Präparathalter als auch das Transmissionselektronenmikroskop nicht oder nur eingeschränkt zur Benutzung freigeben. Aufgrund der einfachen Identifikation ist es auch möglich, die Bewegungsmodi eines Goniometers, mit dem ein bestimmter Kippwinkel des Präparathalters eingestellt wird, aufgrund der Art des Präparathalters einfach anzupassen, einzustellen bzw. gegebenenfalls zu begrenzen.

### Bezugszeichenliste

- 1: Elektronenquelle
- 2: Beschleunigungsstufe
- 3: Magnetlinse
- 4: Magnetlinse
- 5: Kondensor-Objektiv-Einfeldlinse
- 5a: Vorfeldblende
- 6: Präparathalter
- 7: Magnetlinse
- 8: Magnetlinse
- 9: Spule
- 10: Detektor
- 11: Versorgungseinheit
- 12: Versorgungseinheit
- 13: Versorgungseinheit
- 14: Versorgungseinheit
- 15: Versorgungseinheit
- 16: Versorgungseinheit
- 17: Griffstück
- 18: Halteelement
- 19: Spule
- 20: Transponder
- 21: Auswerteelektronik
- 22: Barcode
- 23: Laserscanner
- 24: Goniometer
- 25: Säule des Transmissionseleketronenmikroskops
- 26: Goniometersteuerung

## Patentansprüche

1. Elektronenstrahlgerät, insbesondere ein Transmissionselektronenmikroskop, mit.
- mindestens einem Präparathalter (6), der mindestens ein Halteelement (18) zum Halten eines Präparats und mindestens eine Identifikationseinheit (20, 22) aufweist,
- einer Leseeinheit (19, 23) zum berührungslosen Auslesen der Identifikationseinheit (20, 22),
**gekennzeichnet durch**
- ein Goniometer (24), in das der Präparathalter (6) einführbar ist, und
- eine Steuerung (26) zur Steuerung der Bewegungsmodi des Goniometers (24), mit der auf Grundlage der von der Leseeinheit (19, 23) aus der Identifikationseinheit (20, 22) ausgelesenen Identifikationsdaten und in der Steuerung (26) gespeicherter Daten die Bewegungsmodi des Goniometers (24) gesteuert werden.

2. Elektronenstrahlgerät nach Anspruch 1, wobei die Identifikationseinheit (20, 22) aktiv oder passiv ausgebildet ist.

3. Elektronenstrahlgerät nach Anspruch 1 oder 2, wobei die Identifikationseinheit (20, 22) optisch und/oder magnetisch ausgebildet ist.

4. Elektronenstrahlgerät nach mindestens einem der vorangehenden Ansprüche, wobei die Identifikationseinheit (20, 22) durch eine optische und/oder magnetische Leseeinheit (19, 23) auslesbar ausgebildet ist.

5. Elektronenstrahlgerät nach Anspruch 4, wobei die Leseeinheit (23) als Laserscanner ausgebildet ist.

6. Elektronenstrahlgerät nach mindestens einem der vorangehenden Ansprüche, wobei die Identifikationseinheit (20) als Transponder ausgebildet ist, der mindestens eine Hochfrequenzspule aufweist.

7. Elektronenstrahlgerät nach Anspruch 6, wobei der Transponder (20) durch die mindestens eine Empfangsspule aufweisende Leseeinheit (19) auslesbar ausgebildet ist.

8. Elektronenstrahlgerät nach mindestens einem der vorangehenden Ansprüche, wobei die Identifikationseinheit (22) mindestens einen Barcode umfaßt.

9. Elektronenstrahlgerät nach mindestens einem der vorangehenden Ansprüche, wobei der Präparathalter (6) ein Griffstück (17) aufweist, an dem die Identifikationseinheit (20, 22) angeordnet ist.

10. Elektronenstrahlgerät nach mindestens einem der vorangehenden Ansprüche, wobei eine Auswerteelektronik (21) vorgesehen ist.

11. Elektronenstrahlgerät nach mindestens einem der vorangehenden Ansprüche, wobei die Leseeinheit (19, 23) in oder an dem Goniometer (24) angeordnet ist, in das der Präparathalter (6) einführbar ist.

12. Elektronenstrahlgerät nach einem der vorangehenden Ansprüche, wobei die in der Steuerung (26) gespeicherten Daten Datensätze umfassen, die Bewegungsabläufe für mehrere unterschiedliche Präparathalter (6) beschreiben, wobei jeweils ein Datensatz einem bestimmten Präparathalter (6) zugeordnet und nicht veränderbar ist.

13. Elektronenstrahlgerät nach einem der vorangehenden Ansprüche, wobei die Steuerung als Steuerung des Elektronenstrahlgeräts ausgebildet ist.

## Claims

1. Electron beam device, in particular a transmission electron microscope, having
- at least one specimen holder (6) having at least one holding element (18) for holding a specimen, as well as at least one identification unit (20, 22);
- a reading unit (19, 23) for reading the identification unit (20, 22) without contact,
**characterized by**
- a goniometer (24), into which the specimen holder (6) may be inserted, and
- a controller (26) for controlling the movement modes of the goniometer (24), via which controller the movement modes of the goniometer (24) are controlled on the basis of the identification data read by the reading unit (19, 23) from the identification unit (20, 22) and of data stored in the controller (26).

2. Electron beam device according to claim 1, wherein the identification unit (20, 22) is an active or a passive unit.

3. Electron beam device according to claim 1 or 2, wherein the identification unit (20, 22) is an optical and/or magnetic unit.

4. Electron beam device according to at least one of the preceding claims, wherein the identification unit (20, 22) is readable using an optical and/or magnetic reading unit (19, 23).

5. Electron beam device according to claim 4, wherein the reading unit (23) is designed as a laser scanner.

6. Electron beam device according to at least one of the preceding claims, wherein the identification unit (20) is designed as a transponder having at least one high-frequency coil.

7. Electron beam device according to claim 6, wherein the transponder (20) is readable by the reading unit (19) having at least one receiving coil.

8. Electron beam device according to at least one of the preceding claims, wherein the identification unit (22) includes at least one bar code.

9. Electron beam device according to at least one of the preceding claims, wherein the specimen holder (6) has a handle (17) on which the identification unit (20, 22) is situated.

10. Electron beam device according to at least one of the preceding claims, wherein an electronic analyzer system (21) is provided.

11. Electron beam device according to at least one of the preceding claims, wherein the reading unit (19, 23) is situated in or on the goniometer (24), into which the specimen holder (18) may be inserted.

12. Electron beam device according to one of the preceding claims, wherein the data stored in the controller (26) comprise data records describing movement sequences for several different specimen holders (6), wherein each data record is associated with a particular specimen holder (6) and cannot be changed.

13. Electron beam device according to one of the preceding claims, wherein the controller is designed as controller of the electron beam device.

## Revendications

1. Appareil à faisceau électronique, en particulier microscope électronique à transmission, avec
- au moins un dispositif porte-préparation (6), qui présente au moins un élément de maintien (18) pour maintenir une préparation et au moins une unité d'identification (20, 22),
- une unité de lecture (19, 23) en vue d'une lecture sans contact de l'unité d'identification (20, 22),
**caractérisé par**
- un goniomètre (24), dans lequel le dispositif porte-préparation (6) peut être inséré, et
- un dispositif de commande (26), en vue de la commande des modes de déplacement du goniomètre (24), avec lequel les modes de déplacement du goniomètre (24) sont commandés à partir des données d'identification lues par l'unité de lecture (19, 23) et issues de l'unité d'identification (20, 22) et à partir des données mémorisées dans le dispositif de commande (26).

2. Appareil à faisceau électronique selon la revendication 1, dans lequel l'unité d'identification (20, 22) est réalisée sous une forme active ou passive.

3. Appareil à faisceau électronique selon la revendication 1 ou 2, dans lequel l'unité d'identification (20, 22) est réalisée sous une forme optique et/ou magnétique.

4. Appareil à faisceau électronique selon au moins l'une quelconque des revendications précédentes, dans lequel l'unité d'identification (20, 22) est réalisée de manière à pouvoir être lue par une unité de lecture (19, 23) optique et/ou magnétique.

5. Appareil à faisceau électronique selon la revendication 4, dans lequel l'unité de lecture (23) est réalisée sous la forme d'un scanner laser.

6. Appareil à faisceau électronique selon au moins l'une quelconque des revendications précédentes, dans lequel l'unité d'identification (20) est réalisée sous la forme d'un transpondeur qui présente au moins une bobine à haute fréquence.

7. Appareil à faisceau électronique selon la revendication 6, dans lequel le transpondeur (20) est réalisé de manière à pouvoir être lu par l'unité de lecture (19) présentant au moins une bobine réceptrice.

8. Appareil à faisceau électronique selon au moins l'une quelconque des revendications précédentes, dans lequel l'unité d'identification (22) comprend au moins un code-barres.

9. Appareil à faisceau électronique selon au moins l'une quelconque des revendications précédentes, dans lequel le dispositif porte-préparation (6) présente une pièce de préhension (17), sur laquelle est agencée l'unité d'identification (20, 22).

10. Appareil à faisceau électronique selon au moins l'une quelconque des revendications précédentes, dans lequel est prévu un dispositif électronique d'interprétation (21).

11. Appareil à faisceau électronique selon au moins l'une quelconque des revendications précédentes, dans lequel l'unité de lecture (19, 23) est agencée dans ou sur le goniomètre (24) dans lequel le dispositif porte-préparation (6) peut être introduit.

12. Appareil à faisceau électronique selon l'une quelconque des revendications précédentes, dans lequel les données mémorisées dans le dispositif de commande (26) comprennent des jeux de données qui décrivent des déroulements de déplacement pour plusieurs dispositifs porte-préparation (6) différents, un jeu de données étant respectivement affecté à un dispositif porte-préparation (6) déterminé et ne pouvant être modifié.

13. Appareil à faisceau électronique selon l'une quelconque des revendications précédentes, dans lequel le dispositif de commande est réalisé sous la forme d'un dispositif de commande de l'appareil à faisceau électronique.
